# EUROPÄISCHE PATENTSCHRIFT

(11) **EP 2 095 433 B1**
(45) Veröffentlichungstag und Bekanntmachung des Hinweises auf die Patenterteilung: **28.03.2012**
(21) Anmeldenummer: 07847071.3
(22) Anmeldetag: 12.12.2007
(51) Int. Cl.: H01L 33/08, H01L 33/50, H01L 33/10

(54) **HALBLEITERBAUELEMENT UND VERFAHREN ZU DESSEN HERSTELLUNG**
SEMICONDUCTOR COMPONENT AND ASSOCIATED PRODUCTION METHOD
COMPOSANT SEMI-CONDUCTEUR ET SON PROCÉDÉ DE FABRICATION

(30) Priorität: 12.12.2006 DE 102006059612
(43) Veröffentlichungstag der Anmeldung: 02.09.2009
(73) Patentinhaber: Forschungsverbund Berlin E.V., 10179 Berlin (DE)
(72) Erfinder: WEYERS, Markus, 15745 Wildau (DE); ZORN, Martin, 12163 Berlin (DE)
(74) Vertreter: Gulde Hengelhaupt Ziebig & Schneider
(86) Internationale Anmeldenummer: PCT/EP2007/011077
(87) Internationale Veröffentlichungsnummer: WO 2008/071452

(56) Entgegenhaltungen:
- US-A1- 2002 139 984
- US-A1- 2003 006 430

## Beschreibung

Die vorliegende Erfindung betrifft ein Halbleiterbauelement und ein Verfahren zu dessen Herstellung mit den in den Ansprüchen 1 und 8 genannten Merkmalen, insbesondere betrifft die vorliegende Erfindung ein Halbleiterbauelement (sowie ein Verfahren zu dessen Herstellung), welches auf mindestens zwei definierten Wellenlängen mit einem definierten Intensitätsverhältnis emittiert.

Bei der Messung von optischen Größen (wie z. B. der Absorption) besteht das Problem, dass die Messgröße nicht ohne weiteres absolut bestimmt werden kann. Daher ist es häufig notwendig, neben der zur eigentlichen Messung verwendeten elektromagnetischen Strahlung (Signalstrahlung) ein zweites optisches Signal (Referenzstrahlung) unterschiedlicher Wellenlänge zur Normierung zu verwenden. Dabei ist es besonders wünschenswert, dass diese (beiden) Signale mit einem genau definierten Intensitätsverhältnis vorliegen.

Nach dem Stand der Technik ist es bekannt, die beiden Signale durch zwei einzelne, getrennte Halbleiterbauelemente (beispielsweise durch zwei Laserdioden) zu erzeugen.

Dabei besteht jedoch das Problem, dass die beiden Signale durch aufwändige Optiken zusammengeführt werden müssen.

Die US 2003/006430 A1 offenbart auch ein Hableiterbauelement, welches auf zwei definierten Wellenlängen emittiert. Es ist daher Aufgabe der vorliegenden Erfindung, ein kompaktes und preiswert herstellbares optisches Halbleiterbauelement und ein Verfahren zu dessen Herstellung anzugeben, welches auf mindestens zwei definierten Wellenlängen mit einem definierten Intensitätsverhältnis emittiert. Dabei sollen sowohl die Wellenlängen als auch das Intensitätsverhältnis von Signalstrahl und Referenzstrahl äußerst präzise einstellbar sein. Weiterhin soll der Referenzstrahl eine geringe Intensität (vorzugsweise zwischen 0,001% und 15%, besonders bevorzugt zwischen 0,1% und 15%) als der Signalstrahl aufweisen.

Diese Aufgabe wird erfindungsgemäß gelöst durch die Merkmale im kennzeichnenden Teil der Ansprüche 1 (Verfahrensanspruch) und 8 (Vorrichtungsanspruch) im Zusammenwirken mit den Merkmalen im Oberbegriff. Zweckmäßige Ausgestaltungen der Erfindung sind in den Unteransprüchen enthalten.

Der wesentliche Vorteil besteht darin, dass die beiden (oder mehreren) Lumineszenzsignale aus einem einzigen Halbleiterbauelement emittiert werden. Des Weiteren kann das Intensitätsverhältnis der Signale während des Herstellungsprozesses genau eingestellt (d. h. maßgeschneidert) werden.

Die Idee der Erfindung besteht darin, neben einer (halbleitenden) elektrolumineszierenden Schicht eine (halbleitende) photolumineszierende Schicht vorzusehen, wobei diese photolumineszierende Schicht vorzugsweise mittels eines epitaktischen Verfahrens (besonders bevorzugt metallorganische Gasphasenepitaxie, Molekularstrahlepitaxie oder chemischer Gasphasenepitaxie) mit einer relativ geringen Schichtdicke (« 100 µm) ausgebildet wird. Dadurch können die Photolumineszenzeigenschaften der photolumineszierenden Schicht und damit das Intensitätsverhältnis beider Signale (Elektrolumineszenzlicht der elektrolumineszierenden Schicht und Photolumineszenzlicht der photolumineszierenden Schicht) sehr genau eingestellt werden.

Nachfolgend ist unter der Formulierung "eine Schicht auf einer anderen Schicht aufgebracht wird" oder "eine Schicht auf einer anderen Schicht angeordnet ist" zu verstehen, dass die eine Schicht vorzugsweise direkt auf der anderen Schicht angeordnet/ direkt auf die andere Schicht aufgebracht ist, wobei es auch möglich sein soll, dass zwischen der einen Schicht und der anderen Schicht noch weitere Schichten vorhanden sind.

Das erfindungsgemäße Verfahren zur Herstellung eines auf mindestens zwei definierten Wellenlängen emittierenden Halbleiterbauelementes mit einem definierten Intensitätsverhältnis weist nach einer ersten Ausführungsvariante folgende Verfahrensschritte auf: Bereitstellen eines Substrats, Aufbringen einer ersten Ladungsträgerbarrierenschicht auf die Oberseite des Substrats, Aufbringen einer photolumineszierenden Schicht auf die Ladungsträgerbarrierenschicht, Aufbringen einer reflektierenden Schicht auf die photolumineszierende Schicht, wobei die reflektierende Schicht weiterhin als zweite Ladungsträgerbarrierenschicht fungiert, Aufbringen einer aktiven, elektrolumineszierenden Schicht aus mindestens einem anorganischen Halbleiter auf die reflektierende Schicht, wobei die photolumineszierende Schicht zumindest einen Teil des von der elektrolumineszierenden Schicht emittierten Lichts absorbiert und, Aufbringen einer zumindest teilweise transparenten Kontaktschicht auf die aktive, elektrolumineszierende Schicht. Hierdurch können insbesondere geringe Intensitätsverhältnisse (d. h. Intensität des vom Bauelement emittierten Photolumineszenzlichts der photolumineszierenden Schicht zu Intensität des vom Bauelement emittierten Elektrolumineszenzlichts der elektrolumineszierenden Schicht) im Bereich von 0,001 - 15 % (besonders bevorzugt zwischen 0,1% und 15%)) sehr genau eingestellt werden.

Das Substrat soll vorzugsweise keine Photolumineszenz aufweisen. Dies kann durch die Aufbringung eines für das Elektrolumineszenzlicht wirksamen Spiegels (Bragg-Spiegel) zwischen Substrat und Elektrolumineszenzschicht erreicht werden. Dieser Spiegel verhindert die Anregung von Photolumineszenz durch das Elektroluminezenzlicht.

In einer alternativen, bevorzugten Ausführungsvariante wird als Substrat ein photolumineszierendes Substrat (z.B. p-dotiertes GaAs-Substrat) verwendet, das jedoch nicht beidseitig von Ladungsträgerbarrieren umgeben ist. Daher ist die Emission deutlich schwächer als in der Photolumineszenzschicht. Das gleiche gilt analog für die Ladungsträgerbarrierenschicht, die reflektierende Schicht, die elektrolumineszierende Schicht sowie die Kontaktschicht.

Entsprechend weist das erfindungsgemäße Halbleiterbauelement auf: ein Substrat, eine auf dem Substrat angeordnete erste Ladungsträgerbarrierenschicht, eine auf der Ladungsträgerbarrierenschicht angeordnete photolumineszierende Schicht, eine auf der photolumineszierenden Schicht angeordnete reflektierende Schicht, wobei die reflektierende Schicht weiterhin als zweite Ladungsträgerbarrierenschicht fungiert, eine auf der reflektierenden Schicht angeordnete aktive, elektrolumineszierende Schicht aus mindestens einem anorganischen Halbleiter, wobei die photolumineszierende Schicht zumindest einen Teil des von der elektrolumineszierenden Schicht emittierten Lichts absorbiert und, eine auf der aktiven, elektrolumineszierenden Schicht angeordnete, zumindest teilweise transparente Kontaktschicht. (Für das endgültige Bauelement kann die Kontaktschicht im Emissionsbereich abgeätzt werden).

Vorzugsweise werden Ladungsträger über die Kontaktschicht und über das (halbleitende) Substrat in die Halbleiterbauelement injiziert (durch Anlegen eines elektrischen Feldes), so dass die elektrolumineszierende Schicht zu einer Elektrolumineszenz bei einer ersten Wellenlänge angeregt wird, wobei die photolumineszierende Schicht aufgrund des von der elektrolumineszierenden Schicht emittierten Elektrolumineszenzlichts zu einer Photolumineszenz bei einer zweiten Wellenlänge angeregt wird. Alternativ ist es auch möglich, die Ladungsträger über die Kontaktschicht und eine weitere (zweite) Kontaktschicht zu injizieren, wobei die zweite Kontaktschicht vorzugsweise auf der Oberseite/Unterseite des Substrats angeordnet ist.

Neben der ersten Ladungsträgerbarrierenschicht wird die reflektierende Schicht ebenfalls als Ladungsträgerbarrierenschicht ausgebildet. Durch die Einbringung der Ladungsträgerbarrierenschichten, die eine größere Bandlücke als die photolumineszierende Schicht haben, wird erreicht, dass die durch das Licht der elektrolumineszierenden Schicht erzeugten Ladungsträger in der photolumineszierenden Schicht lokalisiert werden bzw. bleiben. Ohne diese Schichten könnten die Ladungsträger durch das Halbleitermaterial diffundieren und wären für den Photolumineszenzprozess verloren, was u.a. zu unreproduzierbaren Photolumineszenzintensitäten führen würde. Die Aufgabe der Ladungsträgerbarrierenschicht besteht mit anderen Worten darin, die Ladungsträger in der Photolumineszenzschicht zu halten, jedoch die sonstige Funktion des Bauelementes nicht zu beeinflussen.

Die Höhe der Ladungsträgerbarriere der Ladungsträgerbarrierenschicht(en) beträgt vorzugsweise 0.1 - 0.9eV (bevorzugter 0.15-0.75 eV und noch bevorzugter 0.4 - 0.75 eV). Dabei soll als Höhe der Ladungsträgerbarriere im Sinne der Anmeldung die Summe der Leitungs- und der Valenzband-Diskontinuitäten zwischen der photolumineszierenden Schicht und der entsprechenden Ladungsträgerbarrierenschicht verstanden werden.

Im bevorzugten Ausführungsbeispiel besteht die Photolumineszenzschicht aus GaAs, die untere (dem Substrat nächstgelegene) Barrierenschicht aus Al_{0.3}Ga_{0.7}As und die obere Barrierenschicht aus alternierenden Schichten von AIAs und Al_{0.5}Ga_{0.5}As (DBR-Spiegel). Der Unterschied in der Bandkante (d.h. die Höhe der Ladungsträgerbarriere) hat in diesem Fall eine Höhe von 0.24 eV (Leitungsband, direkt) + 0.17 eV (Valenzband) = 0.41 eV (gesamt) für Al_{0.3}Ga_{0.7}As und von 0.16 eV (Leitungsband, indirekt) + 0.59 eV (Valenzband) = 0.75 eV (gesamt) für das AlAs.

Vorzugsweise wird vor dem Aufbringen der Ladungsträgerbarrierenschicht eine Pufferschicht auf die Oberseite des Substrats abgeschieden und die Ladungsträgerbarrierenschicht nachfolgend auf die Pufferschicht aufgebracht. Vorzugsweise kontaktiert die photolumineszierende Schicht die erste Ladungsträgerbarrierenschicht direkt (ersten Ausführungsvariante) und/oder die photolumineszierende Schicht kontaktiert die zweite Ladungsträgerbarrierenschicht (erste und zweite Ausführungsvariante) direkt. Vorzugsweise ist die photolumineszierende Schicht direkt von erster Ladungsträgerbarrierenschicht und zweiter Ladungsträgerbarrierenschicht umgeben.

Vorzugsweise werden das Substrat, die erste Ladungsträgerbarrierenschicht, die photolumineszierende Schicht, die zweite Ladungsträgerbarrierenschicht, die elektrolumineszierende Schicht und die Kontaktschicht durch ein (anorganisches) halbleitendes Material ausgebildet. Die Pufferschicht ist vorzugsweise aus dem gleichen Material wie das Substrat (beispielsweise GaAs) ausgebildet und besitzt eine Dicke zwischen 100 nm und 500 nm. Die Pufferschicht dient dazu, nach der Deoxidation des Substrates eine saubere Oberfläche für den nachfolgenden Prozess zur Verfügung zu stellen. Erfindungsgemäß kann jedoch auch auf diese Pufferschicht verzichtet werden, ohne die Funktion des Bauelements einzuschränken,

Erst durch Anordnung der reflektierenden Schicht können in einfacher Weise besonders kleine Intensitätsverhältnisse erreicht werden. Vorzugsweise wird die reflektierende Schicht durch eine Vielzahl von Schichten mit alternierendem Brechungsindex (Distributed Bragg Reflektor (DBR) Spiegel) ausgebildet.

Vorzugsweise sind sämtliche Schichten des Halbleiterbauelements planar ausgebildet. Das erfindungsgemäße Bauelement kann jedoch auch auf nicht-planaren Strukturen hergestellt werden.

In einer bevorzugten Ausführungsvariante wird die reflektierende Schicht mit einer Reflektivität für die Wellenlänge des von der elektrolumineszierenden Schicht emittierten Elektrolumineszenzlichts von größer 20% (bevorzugter größer 80%, besonders bevorzugt größer 90%) und/oder einer Reflektivität für die Wellenlänge des von der photolumineszierenden Schicht emittierten Photolumineszenzlichts von kleiner als 50% (bevorzugter kleiner als 30%, besonders bevorzugt kleiner 10%) ausgebildet.

Vorzugsweise wird ein vorgegebenes Intensitätsverhältnis zwischen der Gesamtintensität des über die zweite Kontaktschicht ausgekoppelten Lichts der photolumineszierenden Schicht und der Gesamtintensität des über die zweite Kontaktschicht ausgekoppelten Lichts der elektrolumineszierenden Schicht durch Wahl der Parameter: Reflektivität der reflektierenden Schicht für die Wellenlänge des von der photolumineszierenden Schicht emittierten Photolumineszenzlichts, Reflektivität der reflektierenden Schicht für die Wellenlänge des von der elektrolumineszierenden Schicht emittierten Elektrolumineszenzlichts, und Umwandlungseffizienz der photolumineszierenden Schicht von absorbiertem Elektrolumineszenzlicht in emittiertes Photolumineszenzlicht, eingestellt. Vorzugsweise wird die Umwandlungseffizienz der photolumineszierenden Schicht eingestellt durch Wahl der Parameter: Dicke der photolumineszierenden Schicht und Absorptionsvermögen der photolumineszierenden Schicht für Licht der Wellenlänge des von der elektrolumineszierenden Schicht emittierten Elektrolumineszenzlichts.

Unter Absorptionsvermögen wird im Sinne dieser Anmeldung das Produkt aus Absorptionskoeffizient und Schichtdicke verstanden.

Die Halbwertsbreite der Emissionen der elektrolumineszierenden Schicht und der photolumineszierenden Schicht liegen vorzugsweise im Bereich von 10 nm bis 100 nm.

Vorzugsweise wird das definierte Intensitätsverhältnis zwischen 0,2 und 0,001, noch bevorzugter zwischen 0,03 und 0,005 eingestellt.

Vorzugsweise werden das Substrat, die erste Ladungsträgerbarrierenschicht, die photolumineszierende Schicht, die zweite Ladungsträgerbarrierenschicht, die elektrolumineszierende Schicht und die Kontaktschicht durch ein anorganisches, halbleitendes Material ausgebildet. Vorzugsweise wird die photolumineszierenden Schicht mit einem Absorptionsvermögen von Licht der Wellenlänge des von der elektrolumineszierenden Schicht emittierten Elektrolumineszenzlichts von größer als 0,6 (noch bevorzugter 0,8 und noch bevorzugter 0,9) ausgebildet. Der Absorptionskoeffizient α liegt vorzugsweise zwischen 8 cm⁻¹ und 50.000 cm⁻¹ (bevorzugter zwischen 5.000 cm⁻¹ und 50.000 cm⁻¹.)

Vorzugsweise wird die photolumineszierende Schicht in eine Schicht eingebettet, die das von der elektrolumineszierenden Schicht emittierten Elektrolumineszenzlicht der Wellenlänge absorbiert und deren Bandlücke größer als die Bandlücke der photolumineszierende Schicht ist, so dass die bei der Absorption erzeugten Ladungsträger in die photolumineszierende Schicht relaxieren und dort dann unter Lichtaussendung rekombinieren.

Noch bevorzugter besteht die photolumineszierende Schicht aus verschiedenen Schichten, die als interne Barrieren und interne photolumineszierende Schichten fungieren, wobei das von der elektrolumineszierenden Schicht emittierte Elektrolumineszenzlicht absorbiert (vorzugsweise zu mindestens 80%) und die Bandlücke der internen Barriere größer als die Bandlücke der internen photolumineszierende Schicht ist, so dass die bei der Absorption erzeugten Ladungsträger in die interne photolumineszierende Schicht relaxieren und dort dann unter Lichtaussendung rekombinieren.

Vorzugsweise wird die photolumineszierenden Schicht mittels eines epitaktischen Verfahrens ausgebildet. Vorzugsweise wird die photolumineszierenden Schicht mittels metallorganischer Gasphasenepitaxie (MOVPE), Molekularstrahlepitaxie (MBE) oder chemischer Gasphasenepitaxie (CVD) ausgebildet. Dadurch ist es insbesondere möglich, die Photolumineszenzeigenschaften der photolumineszierenden Schicht (und damit das Intensitätsverhältnis) sehr genau einzustellen.

Vorzugsweise wird die photolumineszierende Schicht mit einer Schichtdicke von mehr als 10 nm (noch bevorzugter mehr als 20 nm und noch bevorzugter mehr als 30 nm) und mit einer Schichtdicke von weniger als 100 µm (noch bevorzugter weniger als 20 µm) ausgebildet.

Vorzugsweise wird das Substrat, die erste Ladungsträgerbarrierenschicht, die photolumineszierende Schicht, die zweite Ladungsträgerbarrierenschicht als p-leitende Schichten und die Kontaktschicht als n-leitende Schicht ausgebildet. Vorzugsweise wird die photolumineszierende Schicht aus Galliumarsenid ausgebildet. Vorzugsweise wird die photolumineszierende Schicht aus p-dotiertem Galliumarsenid ausgebildet. Vorzugsweise beträgt die Dotierung zwischen 1·10¹⁷ cm⁻³ und 1·10¹⁹ cm⁻³.

Alternativ kann das Substrat, die erste Ladungsträgerbarrierenschicht, die photolumineszierende Schicht, die zweite Ladungsträgerbarrierenschicht als n-leitende Schichten und die Kontaktschicht als p-leitende Schicht ausgebildet werden. Vorzugsweise wird in dieser Ausführungsform die photolumineszierende Schicht aus Galliumarsenid ausgebildet. Vorzugsweise wird die photolumineszierende Schicht dabei aus n-dotiertem Galliumarsenid ausgebildet. Vorzugsweise beträgt die Dotierung zwischen 1·10¹⁷ cm⁻³ und 1 ·10¹⁹ cm⁻³.

Vorzugsweise wird die erste Ladungsträgerbarrierenschicht direkt auf die Oberseite des Substrats aufgebracht, die photolumineszierende Schicht (6) direkt auf der ersten Ladungsträgerbarrierenschicht aufgebracht, die zweite Ladungsträgerbarrierenschicht direkt auf die photolumineszierende Schicht aufgebracht, und die elektrolumineszierende Schicht direkt (Im bevorzugten Ausführungsbeispiel der Erfindung besteht die elektrolumineszierende Schicht aus mehreren Schichten, nämlich Quantentrögen und sie umgebende Barrieren, nämlich 10 InGaP-Quantentröge in AllnGaP-Barrieren. Dies ist aber nicht zwingend erforderlich; die elektrolumineszierende Schicht kann auch aus einer Einzelschicht bestehen) auf der zweiten Ladungsträgerbarrierenschicht aufgebracht.

Vorzugsweise wird die elektrolumineszierenden Schicht mit einer Emissionswellenlänge im Bereich zwischen 400 nm und 900 nm (600 nm und 700 nm bzw. 625 nm und 675 nm) ausgebildet. Vorzugsweise wird erste Ladungsträgerbarrierenschicht durch AlGaAs mit einer Dicke zwischen 10 nm und 5 µm ausgebildet.

In einer besonders bevorzugten Ausführungsvariante der Erfindung ist es vorgesehen, dass das Halbleiterbauelement mindestens zwei photolumineszierende Schichten aufweist, wobei jede der photolumineszierenden Schichten zwischen Substrat und Kontaktschicht angeordnet ist und wobei die mindestens zwei photolumineszierenden Schichten auf unterschiedlichen Wellenlängen emittieren. Die bisher genannten bevorzugten Ausgestaltungen für die photolumineszierende Schicht gelten analog auch für die mindestens zwei photolumineszierende Schichten. Dadurch ist es möglich, ein Halbleiterbauelement vorzusehen, das auf mindestens drei Wellenlängen emittiert. Vorzugsweise wird vor dem Aufbringen der ersten Ladungsträgerbarrierenschicht eine zweite Kontaktschicht aus einem anorganischen, halbleitenden Material auf die Oberseite des Substrats aufgebracht. Alternativ ist es bevorzugt, dass eine zweite Kontaktschicht aus einem anorganischen, halbleitenden Material oder aus einem Metall auf die Unterseite des Substrats aufgebracht wird.

Vorzugsweise wird die erste Ladungsträgerbarrierenschicht, die photolumineszierende Schicht, die zweite Ladungsträgerbarrierenschicht (reflektierende Schicht), die elektrolumineszierende Schicht und die Kontaktschicht nacheinander mittels metallorganischer Gasphasenepitaxie (MOVPE) innerhalb eines kontinuierlichen Herstellungsprozesses aufgebracht.

Vorzugsweise wird vor dem Aufbringen der Kontaktschicht eine Stromspreizschicht auf die elektrolumineszierende Schicht aufgebracht. Vorzugsweise wird auf die Stromspreizschicht eine Ätzstoppschicht aufgebracht. Vorzugsweise wird die Kontaktschicht strukturiert, wobei in Bereichen, über welche das Licht ausgekoppelt werden soll, keine Kontaktschicht ausgebildet wird.

Vorzugsweise wird die erste Ladungsträgerbarrierenschicht durch AlGaAs ausgebildet. Vorzugsweise wird die erste Ladungsträgerbarrierenschicht mit einer Dicke zwischen 10 nm und 5 µm ausgebildet. Vorzugsweise wird die reflektierende Schicht als DBR Spiegel mit einer Dicke von 1 µm bis 50 µm ausgebildet.

Vorzugsweise wird die aktive, elektrolumineszierende Schicht mit einer Dicke zwischen 5 nm und 1000 nm ausgebildet wird. Vorzugsweise wird die aktive, elektrolumineszierende Schicht durch Indiumgalliumphosphid (InGaP) oder Aluminiumindiumgalliumphosphid (AllnGaP) ausgebildet.

Die Erfindung wird nachfolgend anhand eines in der Figur näher dargestellten Ausführungsbeispiels näher erläutert. Es zeigen:

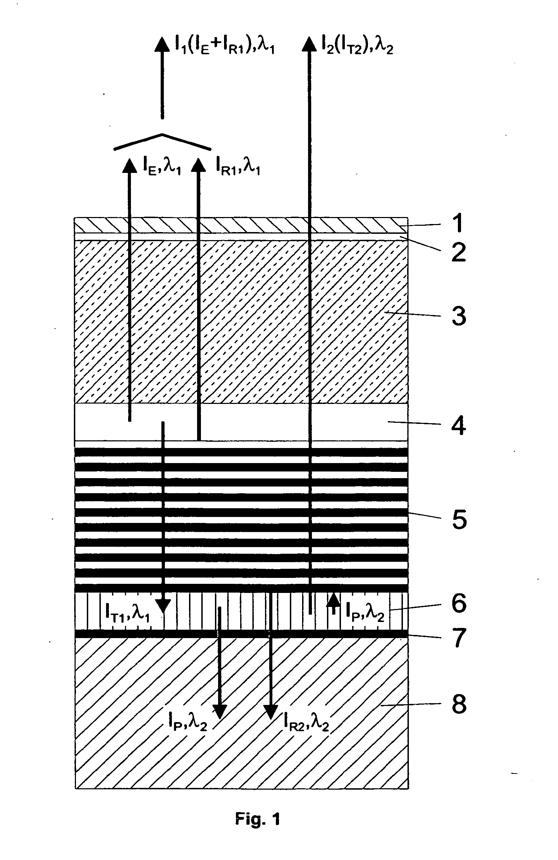

Fig. 1 ein erfindungsgemäßes Halbleiterbauelement in schematischer, geschnittener Darstellung.

Fig. 1 zeigt ein erfindungsgemäßes Halbleiterbauelement in schematischer, geschnittener Darstellung nach einer ersten Ausführungsvariante. Im vorliegenden Ausführungsbeispiel handelt sich um eine GaAs-basierte Leuchtdiode (LED). Diese LED (Halbleiterbauelement) besteht aus einem aktiven Bereich 4, der rotes Licht einer Wellenlänge von λ₁=650 nm mit einer hohen Intensität emittiert. Die Injektion von Ladungsträgern in die elektrolumineszierende Schicht 4 erfolgt einerseits über die Kontaktschicht 1, die (optionale) Ätzstoppschicht 2 und die (optionale) Stromspreizschicht 3 und andererseits über das Substrat 8. Das von der elektrolumineszierenden Schicht 4 emittierte Licht (der Intensität I_{E}) hat eine höhere Photonenenergie oberhalb der Bandlücke des GaAs-Substrates 8 und wird dort absorbiert. Dadurch wird dann Substrat zum Leuchten bei λ₂=870 nm angeregt. Die Emission des Substrats tritt also neben die ursprüngliche Emission des aktiven Bereichs. Aufgabe der vorliegenden Erfindung ist es nun, diese weitere Emission bei λ₂=870 nm in ein genau definiertes Intensitätsverhältnis zur Lichtemissionen bei λ_{1*}=650 nm zu setzen. Dies wird zum einen dadurch erreicht, dass das Licht des roten lichtemittierenden Bereiches durch eine reflektierende Schicht 5 (Bragg-Spiegel-Paket, DBR: distributed Bragg reflector), der sich zwischen dem lichtemittierenden Bereich 4 und dem Substrat 8 befindet, nur zu einem definierten Anteil zum Substrat 8 durchgelassen wird. Das von der elektrolumineszierenden Schicht 4 emittierte Licht wird einerseits mit der Intensität I_{E} nach oben abgestrahlt, andererseits wird es an der Schicht 5 reflektiert (Intensität I_{R1}) und ebenfalls nach oben abgestrahlt (also ausgekoppelt). Der zur Photolumineszenzschicht 6 transmittierte Teil hat die Intensität I_{T1}.

Ein Problem bei der Einstellung der Intensität der Emission aus dem GaAs Substrat 8 besteht nun darin, dass diese stark durch dessen Dotierungsniveau bestimmt wird. Die normalerweise verwendeten Halbleiterwafer werden aus einem langen Einkristall hergestellt. Während des Herstellungsprozesses dieses Einkristalls kann ein konstantes Dotierungsniveau jedoch nicht mit der notwendigen Genauigkeit gewährleistet werden. So hat das Ende des Kristalls normalerweise ein höheres Dotierungsniveau als der Anfang. Damit wird das Verhältnis der Intensitäten bei der Ausgangswellenlänge von λ₁=650 nm zur im Substrat 8 angeregten Emission bei λ₂=870 nm abhängig vom eingesetzten Substrat 8.

Die Idee der vorliegenden Erfindung besteht darin, eine gesonderte photolumineszierende GaAs-Schicht 6 mit einer genau definierten Dicke und Dotierungshöhe zwischen dem Substrat 8 und dem Bragg-Spiegel-Paket 5 einzubringen. Diese wird dann durch eine Ladungsträgerbarriereschicht 7 (hier AlGaAs) vom Substrat 8 getrennt. Durch Kontrolle der Parameter Dicke, Dotierung und Positionierung dieser optisch gepumpten Photolumineszenzschicht 6 lässt sich die Intensität I_{P} der Emission dieser Schicht 6 und damit auch der nach oben ausgekoppelte Anteil I_{T2} genau einstellen bzw. kontrollieren.

In der hier verwendeten Beispielstruktur beträgt die Intensität I_{T2} = I₂ der Emission bei λ₂=870 nm nur 1% der Intensität I₁ = I_{E} + I_{R1} der Lichtemission bei λ₁=650 nm. Diese Emission kann dann z. B. als Intensitätsreferenz genutzt werden.

### Bezugszeichenliste

- 1: Kontaktschicht
- 2: Ätzstoppschicht
- 3: Stromspreizschicht
- 4: aktive, elektrolumineszierende Schicht
- 5: zweite Ladungsträgerbarrierenschicht /reflektierende Schicht/DBR Spiegel
- 6: photolumineszierende Schicht
- 7: erste Ladungsträgerbarrierenschicht
- 8: Substrat

- λ₁: Wellenlänge des von der elektrolumineszierenden Schicht emittierten Lichts
- λ₂: Wellenlänge des von der photolumineszierenden Schicht emittierten Lichts

- I_{E}: Intensität des direkt von der elektrolumineszierenden Schicht in Richtung der Kontaktschicht emittierten Lichts
- I_{R1}: Intensität des an der reflektierenden Schicht reflektierten Lichts der elektrolumineszierenden Schicht
- I_{T1}: Intensität des durch die reflektierende Schicht transmittierten Lichts der elektrolumineszierenden Schicht
- I₁: Gesamtintensität des über die Kontaktschicht ausgekoppelten Lichts der elektrolumineszierenden Schicht
- I_{P}: Intensität des direkt von der photolumineszierenden Schicht emittierten Lichts
- I_{R2}: Intensität des an der reflektierenden Schicht reflektierten Lichts -der photolumineszierenden Schicht
- I_{T2}: Intensität des durch die reflektierende Schicht transmittierten Lichts der photolumineszierenden Schicht
- I₂: Gesamtintensität des über die Kontaktschicht ausgekoppelten Lichts der photolumineszierenden Schicht

## Patentansprüche

1. Verfahren zur Herstellung eines auf zwei definierten Wellenlängen (λ₁, λ₂) emittierenden Halbleiterbauelementes mit einem definierten Intensitätsverhältnis (I₂/I₁) mit folgenden Verfahrensschritten:
- Bereitstellen eines Substrats (8),
- Aufbringen einer ersten Ladungsträgerbarrierenschicht (7) auf die Oberseite des Substrats (8),
- Aufbringen einer photolumineszierenden Schicht (6) auf die Ladungsträgerbarrierenschicht (7),
- Aufbringen einer reflektierenden Schicht (5) auf die photolumineszierende Schicht (6), wobei die reflektierende Schicht (5) weiterhin als zweite Ladungsträgerbarrierenschicht (5) ausgebildet ist,
- Aufbringen einer aktiven, elektrolumineszierenden Schicht (4) aus mindestens einem anorganischen Halbleiter auf die reflektierende Schicht (5), wobei die photolumineszierende Schicht (6) zumindest einen Teil des von der elektrolumineszierenden Schicht (4) emittierten Lichts absorbiert und,
- Aufbringen einer zumindest teilweise transparenten Kontaktschicht (1) auf die aktive, elektrolumineszierende Schicht (4),
- wobei das Substrat (8), die Ladungsträgerbarrierenschicht (7), die photolumineszierende Schicht (6), die reflektierende Schicht (5), die elektrolumineszierende Schicht (4) und die Kontaktschicht (1) jeweils durch ein halbleitendes Material ausgebildet werden,
**dadurch gekennzeichnet, dass**
die reflektierende Schicht (5) mit einer Reflektivitätfürdie Wellenlänge (λ₁) des von der elektrolumineszierenden Schicht (4) emittierten Elektrolumineszenzlichts von größer 80% ausgebildet wird.

2. Verfahren nach Anspruch 1,
**dadurch gekennzeichnet, dass**
die photolumineszierende Schicht (6) mittels eines epitaktischen Verfahrens ausgebildet wird.

3. Verfahren nach einem der vorhergehenden Ansprüche,
**dadurch gekennzeichnet, dass**
die photolumineszierende Schicht (6) mittels metallorganischer Gasphasenepitaxie (MOVPE), Molekularstrahlepitaxie (MBE) oder chemischer Gasphasenepitaxie (CVD) ausgebildet wird.

4. Verfahren nach einem der vorhergehenden Ansprüche,
**dadurch gekennzeichnet, dass**
die photolumineszierende Schicht (6) mit einer Schichtdicke zwischen 10 nm und 20 µm ausgebildet wird.

5. Verfahren nach einem der vorhergehenden Ansprüche,
**dadurch gekennzeichnet, dass**
die photolumineszierende Schicht (6) aus p-dotiertem Galliumarsenid ausgebildet wird und die Dotierung zwischen 1·10¹⁷ cm⁻³ und 1 ·10¹⁹ cm⁻³ beträgt oder die photolumineszierende Schicht (6) aus n-dotiertem Galliumarsenid ausgebildet wird und die Dotierung zwischen 1·10¹⁷ cm⁻³ und 1 ·10¹⁹ cm⁻³ beträgt.

6. Verfahren nach einem der vorhergehenden Ansprüche,
**dadurch gekennzeichnet, dass**
die reflektierende Schicht (5) mit einer Reflektivität für die Wellenlänge (λ₂) des von der photolumineszierenden Schicht (6) emittierten Photolumineszenzlichts von kleiner als 30% und einer Reflektivität für die Wellenlänge (λ₁) des von der elektrolumineszierenden Schicht (4) emittierten Elektrolumineszenzlichts von größer als 90% ausgebildet wird.

7. Verfahren nach einem der vorhergehenden Ansprüche,
**dadurch gekennzeichnet, dass**
die photolumineszierende Schicht (6) mit einem Absorptionsvermögen von Licht der Wellenlänge (λ₁) des von der elektrolumineszierenden Schicht (4) emittierten Elektrolumineszenzlichts von größer als 0,6 ausgebildet wird.

8. Halbleiterbauelement, aufweisend:
- ein Substrat (8),
- eine auf dem Substrat (8) angeordnete erste Ladungsträgerbarrierenschicht (7),
- eine auf der ersten Ladungsträgerbarrierenschicht (7) angeordnete photolumineszierende Schicht (6),
- eine auf der photolumineszierenden Schicht (6) angeordnete reflektierende Schicht (5), wobei die reflektierende Schicht (5) weiterhin als zweite Ladungsträgerbarrierenschicht (5) ausgebildet ist,
- eine auf der reflektierenden Schicht (5) angeordnete aktive, elektrolumineszierende Schicht (4) aus mindestens einem anorganischen Halbleiter, wobei die photolumineszierende Schicht (6) zumindest einen Teil des von der elektrolumineszierenden Schicht (4) emittierten Lichts absorbiert und,
- eine auf der aktiven, elektrolumineszierenden Schicht (4) angeordnete, zumindest teilweise transparente Kontaktschicht (1),
- wobei das Substrat (8), die erste Ladungsträgerbarrierenschicht (7), die photolumineszierende Schicht (6), die reflektierenden Schicht (5), die elektrolumineszierende Schicht (4) und die Kontaktschicht (1) durch ein halbleitendes Material ausgebildet sind,
**dadurch gekennzeichnet, dass**
die reflektierenden Schicht (5) eine Reflektivität für die Wellenlänge (λ₁) des von der elektrolumineszierenden Schicht (4) emittierten Elektrolumineszenzlichts von größer 80% aufweist.

9. Halbleiterbauelement nach Anspruch 8,
**dadurch gekennzeichnet, dass**
die photolumineszierende Schicht (6) die erste Ladungsträgerbarrierenschicht (7) direkt kontaktiert und/oder die photolumineszierende Schicht (6) die reflektierende Schicht (5) direkt kontaktiert.

10. Halbleiterbauelement nach einem der Ansprüche 8 und 9,
**dadurch gekennzeichnet, dass**
die reflektierende Schicht (5) durch einen DBR-Spiegel ausgebildet ist.

11. Halbleiterbauelement nach einem der Ansprüche 8 - 10,
**dadurch gekennzeichnet, dass**
die photolumineszierende Schicht (6) ein Absorptionsvermögen von Licht der Wellenlänge (λ₁) des von der elektrolumineszierenden Schicht (4) emittierten Elektrolumineszenzlichts von größer als 0,6 aufweist.

12. Halbleiterbauelement nach einem der Ansprüche 8 -11,
**dadurch gekennzeichnet, dass**
die photolumineszierende Schicht (6) eine Schichtdicke zwischen 10 nm und 20 µm aufweist.

13. Halbleiterbauelement nach einem der Ansprüche 8-12,
**dadurch gekennzeichnet, dass**
die elektrolumineszierende Schicht (4) mit einer Emissionswellenlänge (λ₁) im Bereich zwischen 600 nm und 700 nm ist.

14. Halbleiterbauelement nach einem der Ansprüche 8-12,
**dadurch gekennzeichnet, dass**
die erste Ladungsträgerbarrierenschicht (7) durch AlGaAs ausgebildet ist und eine Dicke zwischen 10 nm und 5 µm aufweist.

## Claims

1. A method for producing a semiconductor component that emits at two defined wavelengths (λ₁, λ₂) and has a defined intensity ratio (I₂/I₁), comprising the method steps of:
- Providing a substrate (8),
- Applying a first charge carrier barrier layer (7) to the top side of the substrate (8),
- Applying a photoluminescent layer (6) to the charge carrier barrier layer (7),
- Applying a reflective layer (5) to the photoluminescent layer (6), wherein the reflective layer (5) is further designed as a second charge carrier barrier layer (5),
- Applying an active, electroluminescent layer (4) made of at least one inorganic semiconductor to the reflective layer (5), wherein the photoluminescent layer (6) absorbs at least part of the light emitted by the electroluminescent layer (4), and
- Applying an at least partly transparent contact layer (1) to the active, electroluminescent layer (4),
- wherein the substrate (8), the charge carrier barrier layer (7), the photoluminescent layer (6), the reflective layer (5), the electroluminescent layer (4) and the contact layer (1) are each formed of a semiconducting material,
**characterized in that**
the reflective layer (5) is designed to have a reflectivity of more than 80% for the wavelength (λ₁) of the electroluminescent light emitted by the electroluminescent layer (4).

2. A method according to claim 1,
**characterized in that**
the photoluminescent layer (6) is formed by means of an epitaxial method.

3. A method according to any one of the preceding claims,
**characterized in that**
the photoluminescent layer (6) is formed by means of metal-organic vapour phase epitaxy (MOVPE), molecular beam epitaxy (MBE) or chemical vapour phase epitaxy (CVD).

4. A method according to any one of the preceding claims,
**characterized in that**
the photoluminescent layer (6) is formed with a layer thickness of between 10 nm and 20 µm.

5. A method according to any one of the preceding claims,
**characterized in that**
the photoluminescent layer (6) is formed of p-doped gallium arsenide and the doping ranges between 1·10¹⁷ cm⁻³ and 1·10¹⁹ cm⁻³, or the photoluminescent layer (6) is formed of n-doped gallium arsenide and the doping ranges between 1·10¹⁷ cm⁻³ and 1·10¹⁹ cm⁻³_{.}

6. A method according to any one of the preceding claims,
**characterized in that**
the reflective layer (5) is designed to have a reflectivity of less than 30% for the wavelength (λ₂) of the photoluminescent light emitted by the photoluminescent layer (6), and a reflectivity of more than 90% for the wavelength (λ₁) of the electroluminescent light emitted by the electroluminescent layer (4).

7. A method according to any one of the preceding claims,
**characterized in that**
the photoluminescent layer (6) is designed to have an absorption capacity of more than 0.6 for light of the wavelength (λ₁) of the electroluminescent light emitted by the electroluminescent layer (4).

8. A semiconductor component, comprising:
- a substrate (8),
- a first charge carrier barrier layer (7) arranged on the substrate (8),
- a photoluminescent layer (6) arranged on the first charge carrier barrier layer (7),
- a reflective layer (5) arranged on the photoluminescent layer (6), wherein the reflective layer (5) is further designed as a second charge carrier barrier layer (5),
- an active, electroluminescent layer (4) arranged on the reflective layer (5) and made of at least one inorganic semiconductor, wherein the photoluminescent layer (6) absorbs at least part of the light emitted by the electroluminescent layer (4), and
- an at least partly transparent contact layer (1) arranged on the active, electroluminescent layer (4),
- wherein the substrate (8), the first charge carrier barrier layer (7), the photoluminescent layer (6), the reflective layer (5), the electroluminescent layer (4) and the contact layer (1) are formed of a semiconducting material,
**characterized in that**
the reflective layer (5) has a reflectivity of more than 80% for the wavelength (λ₁) of the electroluminescent light emitted by the electroluminescent layer (4).

9. A semiconductor component according to claim 8,
**characterized in that**
the photoluminescent layer (6) is in direct contact with the first charge carrier barrier layer (7), and/or the photoluminescent layer (6) is in direct contact with the reflective layer (5).

10. A semiconductor component according to either of claims 8 and 9,
**characterized in that**
the reflective layer (5) is formed of a DBR mirror.

11. A semiconductor component according to any one of claims 8-10,
**characterized in that**
the photoluminescent layer (6) has an absorption capacity of more than 0.6 for light of the wavelength (λ₁) of the electroluminescent light emitted by the electroluminescent layer (4).

12. A semiconductor component according to any one of claims 8-11,
**characterized in that**
the photoluminescent layer (6) has a layer thickness of between 10 nm and 20 µm.

13. A semiconductor component according to any one of claims 8-12,
**characterized in that**
the electroluminescent layer (4) has an emission wavelength (λ₁) ranging between 600 nm and 700 nm.

14. A semiconductor component according to any one of claims 8-12,
**characterized in that**
the first charge carrier barrier layer (7) is formed of AlGaAs and has a thickness of between 10 nm and 5 µm.

## Revendications

1. Procédé de fabrication d'un composant semi-conducteur émettant sur deux longueurs d'onde (λ₁, λ₂) définies, avec un rapport d'intensité (I₂/I₁) défini, avec les étapes de procédé suivantes :
- fourniture d'un substrat (8),
- mise en place d'une première couche barrière des porteurs de charge (7) sur le côté supérieur du substrat (8),
- mise en place d'une couche photoluminescente (6) sur la couche barrière des porteurs de charge (7),
- mise en place d'une couche réfléchissante (5) sur la couche photoluminescente (6), la couche réfléchissante (5) étant en outre constituée en tant que deuxième couche barrière des porteurs de charge (5),
- mise en place d'une couche électroluminescente (4) active composée d'au moins un semi-conducteur inorganique sur la couche réfléchissante (5), la couche photoluminescente (6) absorbant au moins une partie de la lumière émise par la couche électroluminescente (4),
- mise en place d'une couche de contact (1) au moins partiellement transparente sur la couche électroluminescente (4) active,
- le substrat (8), la couche barrière des porteurs de charge (7), la couche photoluminescente (6), la couche réfléchissante (5), la couche électroluminescente (4) et la couche de contact (1) étant respectivement constitués d'un matériau semi-conducteur,
**caractérisé en ce que**
la couche réfléchissante (5) est constituée avec une réflectivité de plus de 80 % pour la longueur d'onde (λ₁) de la lumière électroluminescente émise par la couche électroluminescente (4).

2. Procédé selon la revendication 1,
**caractérisé en ce que**
la couche photoluminescente (6) est constituée au moyen d'un procédé épitaxial.

3. Procédé selon une des revendications précédentes,
**caractérisé en ce que**
la couche photoluminescente (6) est constituée au moyen de l'épitaxie en phase gazeuse aux organométalliques (MOVPE), de l'épitaxie par jets moléculaires (MBE) ou de l'épitaxie en phase gazeuse chimique (CVD).

4. Procédé selon une des revendications précédentes,
**caractérisé en ce que**
la couche photoluminescente (6) est constituée avec une épaisseur de couche entre 10 nm et 20 µm.

5. Procédé selon une des revendications précédentes,
**caractérisé en ce que**
la couche photoluminescente (6) est constituée d'arséniure de gallium dopé p, et **en ce que** le dopage est entre 1.10¹⁷ cm⁻³ et 1.10¹⁹ cm⁻³, ou **en ce que** la couche photoluminescente (6) est constituée d'arséniure de gallium dopé n, et **en ce que** le dopage est entre 1.10¹⁷ cm⁻³ et 1.10¹⁹ cm⁻³.

6. Procédé selon une des revendications précédentes,
**caractérisé en ce que**
la couche réfléchissante (5) est constituée avec une réflectivité inférieure à 30 % pour la longueur d'onde (λ₂) de la lumière photoluminescente émise par la couche photoluminescente (6), et avec une réflectivité supérieure à 90 % pour la longueur d'onde (λ₁) de la lumière électroluminescente émise par la couche électroluminescente (4).

7. Procédé selon une des revendications précédentes,
**caractérisé en ce que**
la couche photoluminescente (6) est constituée avec un pouvoir d'absorption de lumière supérieur à 0,6 de la longueur d'onde (λ₁) de la lumière électroluminescente émise par la couche électroluminescente (4).

8. Composant semi-conducteur, présentant :
- un substrat (8),
- une première couche barrière des porteurs de charge (7) disposée sur le substrat (8),
- une couche photoluminescente (6) disposée sur la première couche barrière des porteurs de charge (7),
- une couche réfléchissante (5) disposée sur la couche photoluminescente (6), la couche réfléchissante (5) étant en outre constituée en tant que deuxième couche barrière des porteurs de charge (5),
- une couche électroluminescente (4) active disposée sur la couche réfléchissante (5), composée d'au moins un semi-conducteur inorganique, la couche photoluminescente (6) absorbant au moins une partie de la lumière émise par la couche électroluminescente (4),
- une couche de contact (1) au moins partiellement transparente disposée sur la couche électroluminescente (4) active,
- le substrat (8), la première couche barrière des porteurs de charge (7), la couche photoluminescente (6), la couche réfléchissante (5), la couche électroluminescente (4) et la couche de contact (1) étant respectivement constitués d'un matériau semi-conducteur,
**caractérisé en ce que**
la couche réfléchissante (5) est constituée avec une réflectivité de plus de 80 % pour la longueur d'onde (λ₁) de la lumière électroluminescente émise par la couche électroluminescente (4).

9. Composant semi-conducteur selon la revendication 8,
**caractérisé en ce que**
la couche photoluminescente (6) entre directement en contact avec la première couche barrière des porteurs de charge (7), et/ou **en ce que** la couche photoluminescente (6) entre directement en contact avec la couche réfléchissante (5).

10. Composant semi-conducteur selon une des revendications 8 et 9,
**caractérisé en ce que**
la couche réfléchissante (5) est constituée d'un miroir DBR.

11. Composant semi-conducteur selon une des revendications 8 - 10,
**caractérisé en ce que**
la couche photoluminescente (6) présente un pouvoir d'absorption de lumière supérieur à 0,6 de la longueur d'onde (λ₁) de la lumière électroluminescente émise par la couche électroluminescente (4).

12. Composant semi-conducteur selon une des revendications 8-11,
**caractérisé en ce que**
la couche photoluminescente (6) présente une épaisseur de couche entre 10 nm et 20 µm.

13. Composant semi-conducteur selon une des revendications 8 - 12,
**caractérisé en ce que**
la couche électroluminescente (4) est avec une longueur d'onde d'émission (λ₁) dans la plage entre 600 nm et 700 nm.

14. Composant semi-conducteur selon une des revendications 8 - 12,
**caractérisé en ce que**
la première couche barrière des porteurs de charge (7) est constituée de AlGaAs et présente une épaisseur entre 10 nm et 5 µm.
